# EUROPEAN PATENT APPLICATION

(11) **EP 4 766 098 A1**
(43) Date of publication of application: **24.06.2026**
(21) Application number: 25760689.7
(22) Date of filing: 17.01.2025
(51) Int. Cl.: H10F 19/37, H10F 19/80, H10F 71/00

(54) **PANEL AND PREPARATION METHOD THEREFOR, AND PHOTOVOLTAIC MODULE**

(30) Priority: 26.02.2024 CN 202410214118; 02.01.2025 CN 202510009439
(71) Applicant: Shenzhen Hello Tech Energy Co., Ltd, Shenzhen, Guangdong 518109 (CN)
(72) Inventor: TANG, Wei, Shenzhen, Guangdong 518109 (CN); ZHANG, Minhuan, Shenzhen, Guangdong 518109 (CN); SUN, Zhongwei, Shenzhen, Guangdong 518109 (CN); YU, Huajun, Shenzhen, Guangdong 518109 (CN)
(74) Representative: Dehns Germany Partnerschaft mbB
(86) International application number: PCT/CN2025/073012
(87) International publication number: WO 2025/180145

(57) **Abstract**

Provided are a panel and a method for preparing the same, and a photovoltaic module. The panel includes a visual board and a coating. The visual board includes a plurality of coated regions arranged in an array and non-coated regions defined by the plurality of coated regions. The coating is applied on each of the plurality of coated regions.

## Description

### PRIORITY INFORMATION

This application claims priorities to and benefits of Chinese patent application No. 202410214118.8, filed with China National Intellectual Property Administration on February 26, 2024, and Chinese patent application No. 202510009439.9, filed with China National Intellectual Property Administration on January 2, 2025, the entire contents of which are incorporated herein by reference.

### FIELD

The present disclosure relates to the field of photovoltaic technologies, and particularly, to a panel and a method for preparing the same, and a photovoltaic module.

### BACKGROUND

With the development of photovoltaic technologies, an application of photovoltaic modules has become an important subfield in the field of photovoltaic technologies. Currently, in addition to requiring the photovoltaic module to provide satisfactory photoelectric performance, the market also demands attractive appearances with vibrant colors. As a result, screen-printed photovoltaic glass and photovoltaic modules thereof have gained market popularity, leading to promotion of products such as curved roof tiles, integrated vehicle rooftop photovoltaic modules, and glass curtain walls.

Most conventional screen-printing technologies involve full-surface screen printing or coating on a glass surface. After the screen printing, light transmittance of the glass suffers a great loss, resulting in relatively low output power for the photovoltaic module. In conventional screen printing with ink, the ink is dried and cured through heating, followed by tempering. During the tempering, the ink is prone to discoloration and distortion at a high temperature. While high-temperature-resistant ink can be used for the screen printing, a range of available colors is limited, making it difficult to meet dual demands of a customer for both appearance and power.

### SUMMARY

**In** a first aspect of the present disclosure, a panel is provided.

**In** a second aspect of the present disclosure, a photovoltaic module is provided.

In a third aspect of the present disclosure, a method for preparing a panel is provided.

In a fourth aspect of the present disclosure, another panel is provided.

In a fifth aspect of the present disclosure, another photovoltaic module is provided.

In a sixth aspect of the present disclosure, yet another panel is provided.

In a seventh aspect of the present disclosure, another method for preparing a panel is provided.

In an eighth aspect of the present disclosure, yet another photovoltaic module is provided.

A panel in the first aspect of the present disclosure is applied in a photovoltaic module. The panel includes: a visual board including coated regions and non-coated regions defined by the coated regions; and a coating applied on each of the coated regions.

The panel provided in the present disclosure includes the visual board. The visual board includes the coated regions and the non-coated regions defined by the coated regions. The coating is applied on each of the coated regions. In the panel of the present disclosure, the coated regions and the non-coated regions are disposed on a side of the visual board, and the coating is applied on each of the coated region. In this way, overall screen printing is adjusted to partial screen printing, which not only ensures overall aesthetics of the panel of the photovoltaic module, but also guarantees that the photovoltaic module has high light transmittance and therefore has high generated power, reducing losses in a power generation efficiency due to unsatisfactory light transmittance. The visual board in the present disclosure may be a glass board or other types of visual boards.

In the above technical solution, in an implementation, the coated regions are provided as at least two in number, and the at least two coated regions are arranged in an array. A spacing between two adjacent coated regions of the coated regions ranges from 5 mm to 10 mm; and/or each of the coated regions has a width and a length each ranging from 2 mm to 5 mm.

In this technical solution, by limiting the spacing between the two adjacent coated regions of the coated regions and the width and the length of each of the coated regions, the coated regions and the non-coated regions can be arranged alternately at intervals, which avoids a problem of the coated regions being too concentrated or too dispersed, improving an overall visual effect.

In the above technical solution, in an implementation, a quantity of coated regions per square inch of the visual board is greater than or equal to 10 and smaller than or equal to 1,000.

In this technical solution, by limiting the quantity of coated regions per square inch of the visual board, the problem of the coated regions being too concentrated or too dispersed can be avoided, which improves an aesthetic appeal and the light transmittance.

In the above technical solution, in an implementation, the quantity of coated regions per square inch of the visual board is greater than or equal to 150 and smaller than or equal to 250.

In this technical solution, by limiting the quantity of coated regions per square inch of the visual board to range from 150 to 250, the aesthetic appeal and the light transmittance are further improved.

In the above technical solution, in an implementation, the panel further includes at least two positioning holes spaced apart at the visual board, each of the at least two positioning holes extending in a thickness direction of the visual board.

In this technical solution, by forming the at least two positioning holes at the panel, the visual board can be accurately positioned with a screen mold, enabling the visual board to be tightly attached to the screen mold. In this way, continuous precision printing can be performed on the visual board, which offers advantages of a high printing efficiency and strong practicality and avoids a positional shift during the printing.

In the above technical solution, in an implementation, a maximum distance between any two points in each of the coated regions is a first distance; and a minimum distance between any two adjacent coated regions of the coated regions is a second distance, a ratio of the first distance to the second distance being greater than or equal to 0.5 and smaller than or equal to 1.5.

In this technical solution, by limiting a length of the coated region to be approximately equal to the spacing between the coated regions, the coated regions and the non-coated regions can be distributed more evenly, without causing the problem of the coated regions being too concentrated or too dispersed, improving the overall visual effect.

In the above technical solution, in an implementation, the coating is made of transparent pearlescent ink.

In this technical solution, a regular coating is changed to the coating made of the transparent pearlescent ink. During tempering, the transparent pearlescent ink is less prone to discoloration or distortion caused by a high temperature, which allows for a selection of a high-temperature coating for the screen printing, improving a printing efficiency.

In the above technical solution, in an implementation, the transparent pearlescent ink is capable of absorbing light having a wavelength greater than or equal to 100 nm and smaller than 300 nm; and the transparent pearlescent ink is capable of transmitting light having a wavelength greater than or equal to 300 nm and smaller than or equal to 1,100 nm.

In this technical solution, the transparent pearlescent ink exhibits satisfactory light transmission performance, allowing visible light, some ultraviolet light, and some near-infrared light to pass through. In this way, the panel can have satisfactory light transmission performance and therefore have high generated power, reducing the losses in the power generation efficiency due to the unsatisfactory light transmittance.

In the above technical solution, in an implementation, the panel has light transmittance greater than or equal to 85%.

In this technical solution, since the overall screen printing is adjusted to screen printing only on the coated regions, not only the overall aesthetics of the panel of the photovoltaic module is ensured, but also the light transmittance of the panel is greater than or equal to 85%, ensuring that the photovoltaic module has high generated power.

In the above technical solution, in an implementation, the coating has a thickness greater than or equal to 20 µm and smaller than or equal to 30 µm.

In this technical solution, the thickness of the coating should not be too high, as the excessively thick coating leads to unsatisfactory light transmittance, reducing the generated power. On the other hand, the thickness of the coating should not be too low, as the overly thin coating compromises the overall aesthetics.

In the above technical solution, in an implementation, the visual board includes a curved structure having a radius greater than or equal to 30 mm and smaller than or equal to 150 mm.

In this technical solution, if an arc radius is too large, a flattened peak is caused, which is unfavorable for light dispersion; if the arc radius is too small, challenges are posed to manufacturing of the panel. Therefore, setting the radius of the curved structure to range from 30 mm to 150 mm can ensure effective light dispersion while facilitating the manufacturing of the panel. For example, the radius of the curved structure may be 40 mm, 80 mm, or 120 mm.

In the above technical solution, in an implementation, the visual board has a thickness greater than or equal to 3 mm and smaller than or equal to 8 mm.

In this technical solution, the thickness of the visual board should not be too high, as the excessively thick visual board hinders the light dispersion and increases manufacturing costs. Likewise, if the thickness of the visual board is too low, mechanical strength of the visual board is decreased, making the visual board prone to damage under an external force. Therefore, optimally, the thickness is controlled to be greater than or equal to 3 mm and smaller than or equal to 8 mm, such as 4 mm, 5 mm, or 6 mm.

According to technical solutions in the second aspect of the present disclosure, a photovoltaic module is provided. The photovoltaic module includes the panel according to any of the technical solutions in the first aspect of the present disclosure.

Since the photovoltaic module provided in the present disclosure includes the panel according to any of the technical solutions in the first aspect of the present disclosure, the photovoltaic module possesses all the advantageous effects of the panel according to any of the technical solutions in the first aspect of the present disclosure, and thus details thereof will be omitted here.

In some technical solutions, in an implementation, the photovoltaic module further includes: a backplane layer disposed on a side of the panel facing away from the coating; a battery layer disposed between the backplane layer and the panel; a first adhesive layer disposed between the panel and the battery layer; and a second adhesive layer disposed between the backplane layer and the battery layer.

In these technical solutions, the first adhesive layer may be a high-cutoff encapsulation adhesive film, preferably one of a high-cutoff EVA adhesive film, a high-cutoff POE adhesive film, a high-cutoff EPE adhesive film, or a high-cutoff PVB adhesive film, and has a thickness ranging from 0.5 mm to 0.8 mm. The battery layer is preferably a cell without metallic grid lines, where both positive and negative metallic electrodes are led out from a back surface of the cell, such as an XBC cell, an MWT cell, or a shingled cell. In an implementation, the battery layer may be a cell having grid lines at both a front surface and a back surface of the cell, such as a PERC cell, a TOPCON cell, or an HJT cell. The second adhesive layer may be a highly transparent encapsulation adhesive film, preferably one of a high-cutoff EVA adhesive film, a high-cutoff POE adhesive film, a high-cutoff EPE adhesive film, or a high-cutoff PVB adhesive film, and has a thickness ranging from 0.5 mm to 0.8 mm. The backplane layer is made of a flexible polymer material, such as PET, CPC, and HPC, and has a thickness ranging from 0.4 mm to 0.8 mm. In the present disclosure, the backplane layer is made of the flexible polymer material, allowing the backplane layer to be bent into different shapes to suit various mounting substrates. In addition, a choice of the battery layer can further improve the power generation efficiency.

In the third aspect of the present disclosure, a method for preparing a panel is provided. The method includes: treating a visual board using a lipophilic treatment agent, the visual board including coated regions and non-coated regions defined by the coated regions; and preparing a coating on each of the coated regions using a screen mold to obtain the panel.

The method for preparing the panel of the present disclosure includes treating the visual board using the lipophilic treatment agent, which can improve bonding strength between the coating and the visual board subsequent to the screen printing. The visual board includes the coated regions and the non-coated regions defined by the coated regions. The coating is prepared at each of the coated regions using the screen mold to obtain the panel. In the present disclosure, the overall screen printing is adjusted to the partial screen printing, which not only ensures the overall aesthetics of the panel of the photovoltaic module, but also guarantees that the photovoltaic module has the high generated power, reducing the losses in the power generation efficiency due to the unsatisfactory light transmittance.

In some technical solutions, in an implementation, the lipophilic treatment agent includes at least one of hexamethyldisiloxane, trimethylsiloxane, or dimethylchlorosilane.

In these technical solutions, by selecting the lipophilic treatment agent, bonding strength between ink and the visual board can be further improved, avoiding a problem of ink detachment.

In some technical solutions, in an implementation, the screen mold has through holes corresponding to the coated regions, respectively; and a quantity of through holes per square inch of the screen mold is greater than or equal to 10 and smaller than or equal to 1,000.

In these technical solutions, by limiting the quantity of through holes per square inch of the screen mold, a problem of the coated regions being too concentrated or too dispersed can be avoided, improving both the aesthetic appeal of the panel and the light transmittance.

In some technical solutions, in an implementation, the quantity of through holes per square inch of the screen mold is greater than or equal to 150 and smaller than or equal to 250.

In these technical solutions, by limiting the quantity of through holes per square inch of the screen mold to range from 150 to 250, the aesthetic appeal and the light transmittance can be further improved.

According to a technical solution in the fourth aspect of the present disclosure, a panel is provided. The panel is prepared by the method according to any technical solutions in the third aspect of the present disclosure.

According to a technical solution in the fifth aspect of the present disclosure, a photovoltaic module is provided. The photovoltaic module includes the panel according to the technical solution in the fourth aspect of the present disclosure.

A panel in the sixth aspect of the present disclosure is applied in a photovoltaic module. The panel includes: a visual board including a plurality of coated regions and non-coated regions defined by the plurality of coated regions; and a coating applied on each of the plurality of coated regions, each of the plurality of coated regions having an area greater than or equal to 0.1 mm² and smaller than or equal to 1 mm².

In the panel provided in the present disclosure, the area of each individual coated region is limited to ensure that the coated regions are "small in size." In this way, when opaque ink is used, an overall color of the coating can be ensured to be purer. Further, a loss of the light transmittance can be avoided to improve the power generation efficiency while ensuring an overall color purity of the photovoltaic module.

In some technical solutions, in an implementation, an area of each of the plurality of coated regions is A1; and an area of each of the non-coated regions is A2, where a value of A1/(A1+A2) is greater than or equal to 0.3 and smaller than or equal to 0.7.

In some technical solutions, in an implementation, the value of A1/(A1+A2) is greater than or equal to 0.4 and smaller than or equal to 0.6.

In these technical solutions, a ratio of the area of each of the plurality of coated regions to a total area of the coated region and the non-coated region is greater than or equal to 0.4 and smaller than or equal to 0.6, e.g., 0.5. By further limiting a proportion of the area of the coated region, the color purity is ensured while guaranteeing transparency.

In some technical solutions, in an implementation, each of the plurality of coated regions has an area greater than or equal to 0.3 mm² and smaller than or equal to 0.7 mm². In an implementation, each of the plurality of coated regions has the area of 0.5024mm².

In these technical solutions, the area of each coated region is much smaller than that of a conventional coated region, which can ensure the light transmittance while maintaining a color quality. However, if the area of each coated region is set to be smaller than 0.1 mm², manufacturing difficulty is increased. Therefore, setting the area to range from 0.3 mm² to 0.7 mm² is most appropriate.

In some technical solutions, in an implementation, the coating has light transmittance smaller than or equal to 10%.

In these technical solutions, the coating has the light transmittance smaller than or equal to 10%, making an overall color of the coating purer and less likely to mix with a base color. In an implementation, the coating has the light transmittance smaller than or equal to 5%, e.g., 0. In this way, the overall color purity of the photovoltaic module can be further ensured to avoid a mixture with the base color of a cell panel.

In some technical solutions, in an implementation, the plurality of coated regions include: a plurality of first coated regions arranged at intervals in a length direction of the visual board; and a plurality of second coated regions arranged at intervals in a width direction of the visual board, a shortest distance between two adjacent first coated regions of the plurality of first coated regions being greater than or equal to 0.1 mm and smaller than or equal to 1 mm, and a shortest distance between two adjacent second coated regions of the plurality of second coated regions being greater than or equal to 0.1 mm and smaller than or equal to 1 mm.

In these technical solutions, the plurality of coated regions may be arranged at intervals in the length direction of the visual board, the width direction of the visual board, or in both the length direction and the width direction of the visual board, which can result in higher overall color uniformity. Additionally, since the shortest distance between the two adjacent first coated regions of the plurality of first coated regions is greater than or equal to 0.1 mm and smaller than or equal to 1 mm, and the shortest distance between the two adjacent second coated regions of the plurality of second coated regions is greater than or equal to 0.1 mm and smaller than or equal to 1 mm, a density of the plurality of coated regions can be ensured to guarantee the overall color purity.

In some technical solutions, in an implementation, a shortest distance between two adjacent first coated regions of the plurality of first coated regions is greater than or equal to 0.1 mm and smaller than or equal to 0.3 mm. In an implementation, the shortest distance between the two adjacent first coated regions of the plurality of first coated regions is 0.2 mm.

In some technical solutions, in an implementation, a shortest distance between two adjacent second coated regions of the plurality of second coated regions is greater than or equal to 0.1 mm and smaller than or equal to 0.3 mm. In an implementation, the shortest distance between the two adjacent second coated regions of the plurality of second coated regions is 0.2 mm.

In these technical solutions, by further limiting the distance between the adjacent coated regions, the overall color of the coating can be ensured to be purer. Further, the loss of the light transmittance can be avoided to improve the power generation efficiency while ensuring the overall color quality of the photovoltaic module.

In some technical solutions, in an implementation, the plurality of coated regions are arranged in an array, a shortest distance between two adjacent coated regions of the plurality of coated regions being greater than or equal to 0.1 mm and smaller than or equal to 0.3 mm.

In these technical solutions, in an implementation, the plurality of coated regions being arranged in the array means that the plurality of coated regions can be arrayed in the length direction of the visual board, the width direction of the visual board, or a predetermined direction. The predetermined direction may form an angle with the length direction, e.g., an angle greater than or equal to 40° and smaller than or equal to 50°. For example, the angle may be 45°. In this way, the coating can be arranged in a regular pattern, improving the overall color uniformity.

In some technical solutions, in an implementation, the plurality of coated regions include one or a combination of circular coated regions, elliptical coated regions, diamond-shaped coated regions, and figure-eight-shaped coated regions.

In these technical solutions, coated regions such as the circular coated regions, the elliptical coated regions, the diamond-shaped coated regions, and the figure-eight-shaped coated regions can allow for better printing on the one hand. On the other hand, especially for curved panels, the coated regions of these shapes experience less deformation compared with square coated regions, ensuring the overall color quality.

In some technical solutions, in an implementation, the plurality of coated regions include circular coated regions, each of the circular coated regions having a diameter greater than or equal to 0.5 mm and smaller than or equal to 1.0 mm, and a distance between centers of two adjacent circular coated regions of the circular coated regions being greater than or equal to 0.05 mm and smaller than or equal to 0.3 mm.

In these technical solutions, for the curved panels, the circular coated regions experience less deformation compared with the square coated regions. Further, by limiting the diameter of each of the circular coated regions and the distance between the centers of the two adjacent circular coated regions of the circular coated regions, an overall density of the circular coated regions can be ensured to guarantee the color purity. In an implementation, the diameter of the circular coated region may be 0.8 mm or 1.0 mm, and the distance between the centers of the two adjacent circular coated regions of the circular coated regions may be 0.1 mm or 0.2 mm.

In some technical solutions, in an implementation, the panel includes a curved panel. In this way, the satisfactory power generation efficiency can be achieved for different incident angles of sunlight.

In some technical solutions, in an implementation, the curved panel includes peaks and valleys that are arranged alternately in a first direction; and each of the plurality of coated regions is in a shape of an ellipse, a direction of a minor axis of the ellipse being the same as the first direction.

In these technical solutions, since the direction of the minor axis of the ellipse is the same as the first direction, more elliptical coated regions can be arranged within a same volume, ensuring the color purity. The first direction may also be regarded as a bending direction of the curved panel.

In some technical solutions, in an implementation, the curved panel includes peaks and valleys that are arranged alternately in a first direction; and each of the plurality of coated regions is in a shape of a diamond, the diamond including a first diagonal and a second diagonal, the first diagonal having a greater length than the second diagonal, and an extension direction of the second diagonal being the same as the first direction.

In these technical solutions, when each of the plurality of coated regions is in the shape of the diamond, an extension direction of a shorter diagonal is the same as the first direction, which allows for more coated regions to be arranged within a same volume, ensuring the color purity.

In some technical solutions, in an implementation, any two nearest coated regions of the plurality of coated regions are offset from each other.

In these technical solutions, when each of the plurality of coated regions is in the shape of the diamond, the any two nearest coated regions of the plurality of coated regions are offset from each other, which allows for more coated regions to be arranged within a same volume, ensuring the color purity.

In the seventh aspect of the present disclosure, a method for preparing a panel is provided. The method is applied in preparing the panel according to any of the embodiments in the sixth aspect of the present disclosure. The method includes: preparing the coating on each of the plurality of coated regions using a screen mold; and performing sintering treatment on the visual board printed with the coating to obtain the panel.

With the method of the present disclosure, the overall screen printing is adjusted to the partial screen printing, which not only ensures the overall aesthetics of the panel of the photovoltaic module, but also guarantees that the photovoltaic module has the high generated power, reducing the losses in the power generation efficiency due to the unsatisfactory light transmittance.

In some technical solutions, in an implementation, the method further includes, prior to the preparing the coating on each of the plurality of coated regions using the screen mold: treating a visual board using a lipophilic treatment agent.

In these technical solutions, the visual board is first treated with the lipophilic treatment agent, which can improve the bonding strength between the coating and the visual board subsequent to the screen printing.

In some technical solutions, in an implementation, the lipophilic treatment agent includes at least one of hexamethyldisiloxane, trimethylsiloxane, or dimethylchlorosilane.

In these technical solutions, by selecting the lipophilic treatment agent, the bonding strength between ink and the visual board can be further improved, avoiding the problem of ink detachment.

In some technical solutions, in an implementation, during the sintering treatment, a sintering temperature is greater than or equal to 400°C and smaller than or equal to 1,000°C. In an implementation, the sintering temperature is greater than or equal to 400°C and smaller than or equal to 700°C. For example, the sintering temperature may be 500°C or 600°C.

In some technical solutions, in an implementation, the screen mold has through holes corresponding to the plurality of coated regions, respectively, a quantity of through holes per square inch of the screen mold being greater than or equal to 250 and smaller than or equal to 300.

In this embodiment, limiting the quantity of through holes per square inch of the screen mold to range from 250 to 300 further improves the aesthetic appeal and the light transmittance. In an implementation, the quantity of through holes may be 250, 270, or 300.

According to technical solutions in an eighth aspect of the present disclosure, a photovoltaic module is provided. The photovoltaic module includes: the panel according to any of the technical solutions in the sixth aspect of the present disclosure; or the panel prepared by the method according to any of the technical solutions in the seventh aspect of the present disclosure. Since the photovoltaic module provided in the present disclosure includes the panel according to any of the technical solutions in the sixth aspect of the present disclosure or the panel prepared by the method according to any of the technical solutions in the seventh aspect of the present disclosure, the photovoltaic module possesses all the advantageous effects of the panel according to any of the technical solutions in the sixth aspect of the present disclosure, and thus details thereof will be omitted here.

In some technical solutions, in an implementation, the photovoltaic module further includes a battery layer disposed on a side of the panel, the coating being disposed between the visual board and the battery layer.

In this embodiment, since the coating is disposed between the visual board and the battery layer, the visual board can provide a predetermined level of protection to the coating, to prevent the coating from being damaged by the external force and avoid damage caused by long-term exposure of the coating to an outer side.

Additional aspects and advantages of the present disclosure will be provided at least in part in the following description, or will become apparent at least in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings.
FIG. 1 illustrates a first schematic structural view of a panel according to an embodiment of the present disclosure.
FIG. 2 illustrates an assembled schematic structural view of a screen mold and a panel according to an embodiment of the present disclosure.
FIG. 3 illustrates a first schematic structural view of a photovoltaic module according to an embodiment of the present disclosure.
FIG. 4 illustrates a first flowchart of a method for preparing a panel according to an embodiment of the present disclosure.
FIG. 5 illustrates a second schematic structural view of a photovoltaic module according to an embodiment of the present disclosure.
FIG. 6 illustrates a third schematic structural view of a photovoltaic module according to an embodiment of the present disclosure.
FIG. 7 illustrates a second schematic structural view of a panel according to an embodiment of the present disclosure.
FIG. 8 illustrates a third schematic structural view of a panel according to an embodiment of the present disclosure.
FIG. 9 illustrates a fourth schematic structural view of a panel according to an embodiment of the present disclosure.
FIG. 10 illustrates a fifth schematic structural view of a panel according to an embodiment of the present disclosure.
FIG. 11 illustrates a sixth schematic structural view of a panel according to an embodiment of the present disclosure.
FIG. 12 illustrates an assembled schematic structural view of a screen mold and a panel according to an embodiment of the present disclosure.
FIG. 13 illustrates a second flowchart of a method for preparing a panel according to an embodiment of the present disclosure.

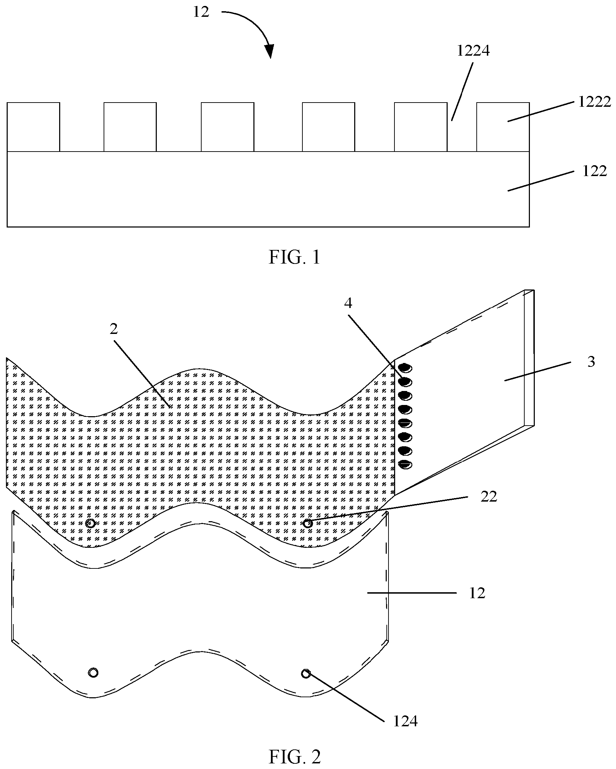

A correspondence between reference numerals and component names in FIG. 1 to FIG. 3 and FIG. 5 to FIG. 12 is as follows:
1 photovoltaic module, 12 panel, 122 visual board, 1222 coated region, 12222 first coated region, 12224 second coated region, 1224 non-coated region, 1226 curved structure, 124 positioning hole, 14 first adhesive layer, 16 battery layer, 172 peak, 174 valley, 184 first diagonal, 186 second diagonal, 18 second adhesive layer, 19 backplane layer, 2 screen mold, 22 mold hole, 24 through hole, 3 squeegee, 4 coating.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limit, the present disclosure.

Various embodiments or examples for implementing different structures of the embodiments of the present disclosure are provided below. In order to simplify the description of the embodiments of the present disclosure, components and arrangements of specific examples are described herein. These specific examples are merely for the purpose of illustration, rather than limiting the present disclosure. Further, the same reference numerals and/or reference letters may appear in different examples of the embodiments of the present disclosure for the purpose of simplicity and clarity, instead of indicating a relationship between different embodiments and/or the discussed arrangements. In addition, the embodiments of the present disclosure provides examples of various specific processes and materials. However, applications of other processes and/or the use of other materials are conceivable for those of ordinary skill in the art.

As illustrated in FIG. 1 and FIG. 2, a panel 12 in a first aspect of the present disclosure is applied in a photovoltaic module 1. The panel 12 includes: a visual board 122 including coated regions 1222 and non-coated regions 1224 defined by the coated regions 1222; and a coating 4 applied on each of the coated regions 1222.

The panel 12 provided in the present disclosure includes the visual board 122. The visual board 122 includes the coated regions 1222 and the non-coated regions 1224 defined by the coated regions 1222. The coating 4 is applied on each of the coated regions 1222. In the panel 12 of the present disclosure, the coated regions1222 and the non-coated regions 1224 are disposed on a side of the visual board 122, and the coating 4 is applied on each of the coated region 1222. In this way, overall screen printing is adjusted to partial screen printing, which not only ensures overall aesthetics of the panel 12, but also guarantees that the photovoltaic module 1 has high light transmittance and therefore has high generated power, reducing losses in a power generation efficiency due to unsatisfactory light transmittance. The visual board 122 in the present disclosure may be a glass board or other types of visual boards.

In the above embodiment, in an implementation, the coated regions 1222 are provided as at least two in number, and the at least two coated regions 1222 are arranged in an array. A spacing between two adjacent coated regions 1222 of the at least two coated regions 1222 ranges from 5 mm to 10 mm; and/or each of the at least two coated regions 1222 has a width and a length each ranging from 2 mm to 5 mm.

In this embodiment, by limiting the spacing between the two adjacent coated regions 1222 of the at least two coated regions 1222 and the width and the length of each of the at least two coated regions 1222, the at least two coated regions 1222 and the non-coated regions 1224 can be arranged alternately at intervals, which avoids a problem of the coated regions 1222 being too concentrated or too dispersed, improving an overall visual effect.

In the above embodiment, in an implementation, a quantity of coated regions 1222 per square inch of the visual board 122 is greater than or equal to 10 and smaller than or equal to 1,000.

In this embodiment, by limiting the quantity of coated regions 1222 per square inch of the visual board 122, the problem of the coated regions 1222 being too concentrated or too dispersed can be avoided, which improves an aesthetic appeal and the light transmittance.

In the above embodiment, in an implementation, the quantity of coated regions 1222 per square inch of the visual board 122 is greater than or equal to 150 and smaller than or equal to 250.

In this embodiment, by limiting the quantity of coated regions 1222 per square inch of the visual board 122 to range from 150 to 250, the aesthetic appeal and the light transmittance are further improved.

In the above embodiment, in an implementation, as illustrated in FIG. 2, the panel 12 further includes at least two positioning holes 124 spaced apart at the visual board 122. Each of the at least two positioning holes 124 extends in a thickness direction of the visual board 122.

In this embodiment, by forming the at least two positioning holes 124 at the panel 12, the visual board 122 can be accurately positioned with a screen mold 2, enabling the visual board 122 to be tightly attached to the screen mold 2. In this way, continuous precision printing can be performed on the visual board 122, which offers advantages of a high printing efficiency and strong practicality and avoids a positional shift during the printing.

In the above embodiment, in an implementation, a maximum distance between any two points in each of the at least two coated regions 1222 is a first distance; and a minimum distance between any two adjacent coated regions 1222 of the at least two coated regions 1222 is a second distance. A ratio of the first distance to the second distance is greater than or equal to 0.5 and smaller than or equal to 1.5.

In this embodiment, by limiting a length of the coated region 1222 to be approximately equal to the spacing between the coated regions 1222, the coated regions 1222 and the non-coated regions 1224 can be distributed more evenly, without causing the problem of the coated regions 1222 being too concentrated or too dispersed, improving the overall visual effect.

In the above embodiment, in an implementation, the coating 4 is made of transparent pearlescent ink.

In this embodiment, the coating 4 may be made of ink, e.g., the transparent pearlescent ink. A regular coating 4 is changed to the coating made of the transparent pearlescent ink. During tempering, the transparent pearlescent ink is less prone to discoloration or distortion caused by a high temperature, which allows for a selection of a high-temperature coating 4 for the screen printing, improving a printing efficiency.

In the above embodiment, in an implementation, the transparent pearlescent ink is capable of absorbing light having a wavelength greater than or equal to 100 nm and smaller than 300 nm; and the transparent pearlescent ink is capable of transmitting light having a wavelength greater than or equal to 300 nm and smaller than or equal to 1,100 nm.

In this embodiment, the transparent pearlescent ink exhibits satisfactory light transmission performance, allowing visible light, some ultraviolet light, and some near-infrared light to pass through. In this way, the panel 12 can have satisfactory light transmission performance and therefore have high generated power, reducing the losses in the power generation efficiency due to the unsatisfactory light transmittance.

In the above embodiment, in an implementation, the panel 12 has light transmittance greater than or equal to 85%.

In this embodiment, since the overall screen printing is adjusted to screen printing only on the coated regions 1222, not only the overall aesthetics of the panel 12 is ensured, but also the light transmittance of the panel 12 is greater than or equal to 85%, ensuring that the photovoltaic module 1 has high generated power.

In the above embodiment, in an implementation, the coating 4 has a thickness greater than or equal to 20 µm and smaller than or equal to 30 µm.

In this embodiment, the thickness of the coating 4 should not be too high, as the excessively thick coating 4 leads to unsatisfactory light transmittance, reducing the generated power. On the other hand, the thickness of the coating 4 should not be too low, as the overly thin coating 4 compromises the overall aesthetics.

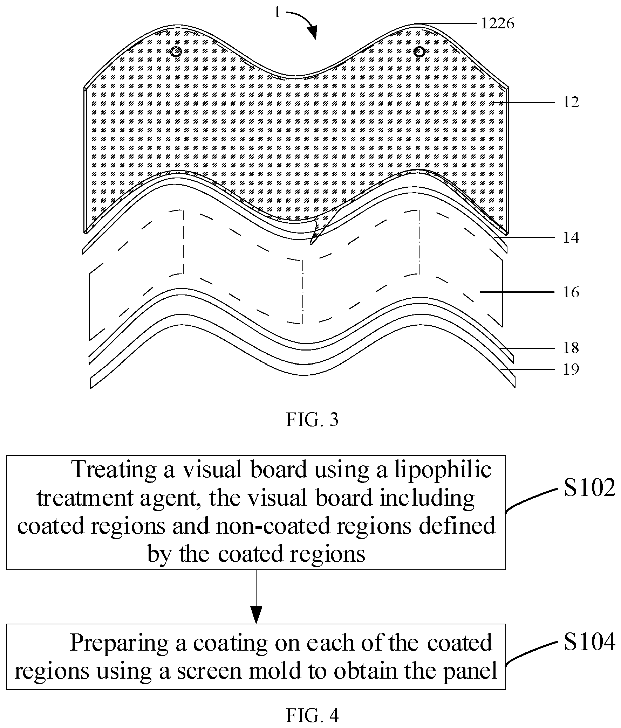

In the above embodiment, in an implementation, as illustrated in FIG. 3, the visual board 122 includes a curved structure 1226 having a radius greater than or equal to 30 mm and smaller than or equal to 150 mm.

In this embodiment, if an arc radius is too large, a flattened peak is caused, which is unfavorable for light dispersion; if the arc radius is too small, challenges are posed to manufacturing of the panel 12. Therefore, setting the radius of the curved structure 1226 to range from 30 mm to 150 mm can ensure effective light dispersion while facilitating the manufacturing of the panel 12. For example, the radius of the curved structure 1226 may be 40 mm, 80 mm, or 120 mm.

In the above embodiment, in an implementation, the visual board 122 has a thickness greater than or equal to 3 mm and smaller than or equal to 8 mm.

In this embodiment, the thickness of the visual board 122 should not be too high, as the excessively thick visual board 122 hinders the light dispersion and increases manufacturing costs. Likewise, if the thickness of the visual board 122 is too low, mechanical strength of the visual board 122 is decreased, making the visual board 122 prone to damage under an external force. Therefore, optimally, the thickness is controlled to be greater than or equal to 3 mm and smaller than or equal to 8 mm, such as 4 mm, 5 mm, or 6 mm.

According to embodiments in a second aspect of the present disclosure, the photovoltaic module 1 is provided. The photovoltaic module 1 includes the panel 12 according to any of the embodiments in the first aspect of the present disclosure.

Since the photovoltaic module 1 provided in the present disclosure includes the panel 12 according to any of the embodiments in the first aspect of the present disclosure, the photovoltaic module 1 possesses all the advantageous effects of the panel 12 according to any of the embodiments in the first aspect of the present disclosure, and thus details thereof will be omitted here.

In some embodiments, in an implementation, as illustrated in FIG. 3, the photovoltaic module 1 further includes: a backplane layer 19 disposed on a side of the panel 12 facing away from the coating 4; a battery layer 16 disposed between the backplane layer 19 and the panel 12; a first adhesive layer 14 disposed between the panel 12 and the battery layer 16; and a second adhesive layer 18 disposed between the backplane layer 19 and the battery layer 16.

In these embodiments, the first adhesive layer 14 may be a high-cutoff encapsulation adhesive film, preferably one of a high-cutoff EVA adhesive film, a high-cutoff POE adhesive film, a high-cutoff EPE adhesive film, or a high-cutoff PVB adhesive film, and has a thickness ranging from 0.5 mm to 0.8 mm. The battery layer 16 is preferably a cell without metallic grid lines, with both positive and negative metallic electrodes led out from a back surface of the cell, such as an XBC cell, an MWT cell, or a shingled cell. In an implementation, the battery layer 16 may be a cell having grid lines at both a front surface and a back surface of the cell, such as a PERC cell, a TOPCON cell, or an HJT cell. The second adhesive layer 18 may be a highly transparent encapsulation adhesive film, preferably one of a high-cutoff EVA adhesive film, a high-cutoff POE adhesive film, a high-cutoff EPE adhesive film, or a high-cutoff PVB adhesive film, and has a thickness ranging from 0.5 mm to 0.8 mm. The backplane layer 19 is made of a flexible polymer material, such as PET, CPC, and HPC, and has a thickness ranging from 0.4 mm to 0.8 mm. In the present disclosure, the backplane layer 19 is made of the flexible polymer material, allowing the backplane layer 19 to be bent into different shapes to suit various mounting substrates. In addition, a choice of the battery layer 16 can further improve the power generation efficiency.

As illustrated in FIG. 4, in a third aspect of the present disclosure, a method for preparing a panel is provided. The method includes operations at blocks.

At S102, a visual board is treated using a lipophilic treatment agent. The visual board includes coated regions and non-coated regions defined by the coated regions.

At S104, a coating is prepared at each of the coated regions using a screen mold to obtain the panel.

The method for preparing the panel of the present disclosure includes treating the visual board 122 using the lipophilic treatment agent, which can improve bonding strength between the coating 4 and the visual board 122 subsequent to the screen printing. The visual board 122 includes the coated regions 1222 and the non-coated regions 1224 defined by the coated regions 1222. The coating 4 is prepared at each of the coated regions 1222 using the screen mold 2 to obtain the panel 12. In the present disclosure, the overall screen printing is adjusted to the partial screen printing, which not only ensures the overall aesthetics of the panel 12, but also guarantees that the photovoltaic module 1 has the high generated power, reducing the losses in the power generation efficiency due to the unsatisfactory light transmittance.

In some embodiments, in an implementation, the lipophilic treatment agent includes at least one of hexamethyldisiloxane, trimethylsiloxane, or dimethylchlorosilane.

In these embodiments, by selecting the lipophilic treatment agent, bonding strength between ink and the visual board 122 can be further improved, avoiding a problem of ink detachment.

In some embodiments, in an implementation, the screen mold 2 has through holes corresponding to the coated regions 1222, respectively; and a quantity of through holes per square inch of the screen mold 2 is greater than or equal to 10 and smaller than or equal to 1,000.

In these embodiments, by limiting the quantity of through holes per square inch of the screen mold 2, a problem of the coated regions 1222 being too concentrated or too dispersed can be avoided, improving both the aesthetic appeal of the panel 12 and the light transmittance.

In some embodiments, in an implementation, the quantity of through holes per square inch of the screen mold 2 is greater than or equal to 150 and smaller than or equal to 250.

In these embodiments, by limiting the quantity of through holes per square inch of the screen mold 2 to range from 150 to 250, the aesthetic appeal and the light transmittance can be further improved.

According to an embodiment in a fourth aspect of the present disclosure, the panel 12 is provided. The panel 12 is prepared by the method according to any embodiments in the third aspect of the present disclosure.

According to an embodiment in a fifth aspect of the present disclosure, the photovoltaic module 1 is provided. The photovoltaic module 1 includes the panel 12 according to the embodiment in the fourth aspect of the present disclosure.

As illustrated in FIG. 2 and FIG. 3, a process for preparing the photovoltaic module 1 is provided according to another embodiment of the present disclosure, which is mainly aimed at overcoming defects of conventional screen printing on the curved panel, and is capable of conveniently bending the screen mold 2 into a desired curved shape, satisfying a demand for precision printing of curved panel products.

Components involved the process are as follows:
Squeegee 3: the squeegee 3 is made of a flexible material, e.g., polyurethane rubber having satisfactory abrasion resistance and resilience. The squeegee 3 has hardness ranging from 60 Shore to 80 Shore, and a width that should be smaller than that of the screen mold 2.

Curved panel: tempered glass customized with a multi-peak and multi-valley arc-shaped curved surface is selected. The curved surface has a radius ranging from 30 mm to 150 mm and a thickness ranging from 3 mm to 8 mm.

Screen mold 2: the screen mold 2 may be a dot matrix screen mold 2, meaning that printing holes in the screen mold 2 are arranged in a dot matrix pattern. The screen mold 2 is in a bending shape designed to match that of the curved panel, and has a length slightly longer than that of the curved panel and a width the same as that of the curved panel. The dot matrix screen mold 2 may be made of one of high-strength, low-shrinkage nylon, polyester, or polyethylene fiber, or may be made of stainless steel. The screen having a mesh count ranging from 150 to 250 is selected. The dot matrix has a diameter ranging from 2 mm to 5 mm and a spacing ranging from 5 mm to 10 mm. The screen mold 2 is positioned through mold holes 22 and the positioning holes 124 at an upper end of the curved panel.

Coating 4: the coating 4 may be made of ink having a color of one of semi-transparent pearlescent inks corresponding to the Pantone color codes PANTONE 1645 CP or 1625 CP. This ink exhibits selective permeability, capable of selectively absorbing ultraviolet light while allowing visible light to pass through. After the screen printing, the panel 12 has light transmittance T>85%.

In the process for preparing the photovoltaic module 1, the curved panel is first turned over to clean an inner surface of the curved panel. The treatment agent may be one of hexamethyldisiloxane, trimethylsiloxane, or dimethylchlorosilane to enhance lipophilicity of the inner surface of the curved panel and improve the bonding strength between the ink and the panel 12 subsequent to the screen printing. After the screen mold 2 is fixed to the curved panel, the screen mold 2 is placed into a screen printing machine. The ink is poured onto the screen mold 2. The screen printing is performed at a speed ranging from 20 m/min to 30 m/min. The ink on the screen mold 2 is evenly spread as it is pushed by the squeegee 3. An ink thickness ranges from 20 µm to 30 µm.

High-temperature sintering treatment is performed on the curved panel subsequent to the screen printing at a temperature ranging from 140°C to 150°C and for a drying duration ranging from 45 min to 60 min. In this way, the ink is rapidly cured and molded to be stably bonded with a surface of the panel 12, and thus the printed curved panel is obtained and used as the panel 12 of the photovoltaic module 1.

After curing, an ink layer exhibits circular stripe patterns and is entirely in a shape conforming to curvature of the curved panel. When viewed closely, the ink layer appears as star-like dots, featuring a vibrant color and a semi-transparent effect. When viewed from a distance, the ink layer presents a uniformly bright golden-red or brick-red color.

After the panel 12 is prepared, the photovoltaic module 1 is prepared by the printed panel 12. A structure of the photovoltaic module 1 includes the curved panel, the first adhesive layer 14, the battery layer 16, the second adhesive layer 18, and the backplane layer 19.

The curved panel is prepared by the above method.

The first adhesive layer 14 may be the high-cutoff encapsulation adhesive film, e.g., the high-cutoff EVA adhesive film, the high-cutoff POE adhesive film, the high-cutoff EPE adhesive film, or the high-cutoff PVB adhesive film, and has the thickness ranging from 0.5 mm to 0.8 mm.

The battery layer 16 may be the cell without metallic grid lines, with both positive and negative metallic electrodes led out from the back surface of the cell, such as the XBC cell, the MWT cell, or the shingled cell. In an implementation, the battery layer 16 may be the cell having grid lines at both the front surface and the back surface of the cell, such as the PERC cell, the TOPCON cell, or the HJT cell.

The second adhesive layer 18 may be the highly transparent encapsulation adhesive film, e.g., one of the high-cutoff EVA adhesive film, the high-cutoff POE adhesive film, the high-cutoff EPE adhesive film, or the high-cutoff PVB adhesive film, and has the thickness ranging from 0.5 mm to 0.8 mm.

The backplane layer 19 is made of the flexible polymer material, such as PET, CPC, and HPC, and has the thickness ranging from 0.4 mm to 0.8 mm.

For the photovoltaic module 1 prepared by the method of the present disclosure, the selective screen printing can be performed on the entire inner surface of the curved panel by adjusting a size of the diameter of the dot matrix, the spacing of the dot matrix, and the mesh count of the screen of the screen mold 2, which improves the overall aesthetics of the curved photovoltaic module 1, ensures the high generated power of the curved photovoltaic module 1, and reduces the losses in the power generation efficiency. By selecting the semi-transparent pearlescent ink, which exhibits selective permeability of absorbing ultraviolet light while selectively allowing visible light to pass through, the losses in the power generation efficiency of the curved screen-printed photovoltaic module 1 is kept below 10%. Further, a semi-transparent visual effect and a consistency of a vibrant overall appearance are highlighted. The customized dot matrix screen mold 2 designed in this solution is tightly attached to the curved panel via the mold holes 22. In this way, the continuous precision printing can be performed on the curved panel, which offers the advantages of the high printing efficiency and the strong practicality.

For colored photovoltaics, some current technologies involve applying colored ink directly over the entire surface of the panel. If the colored ink has low light transmittance, this approach can result in low light transmittance of the entire panel, leading to the unsatisfactory power generation efficiency of the cell. If the colored ink has a predetermined level of transparency, a mixture with the base color is likely to occur, resulting in impure colors of the entire panel. Additionally, some documents disclose applying colored ink over a part of the surface. However, in such cases, since the coated region typically has a large area, the light transmittance of the panel is low when a low-transparency coating or an opaque coating is used, affecting the power generation efficiency. Further, if a semi-transparent coating is used, impure colors are caused. Therefore, conventional photovoltaic panels struggle to achieve both satisfactory color purity and sufficient light transmittance.

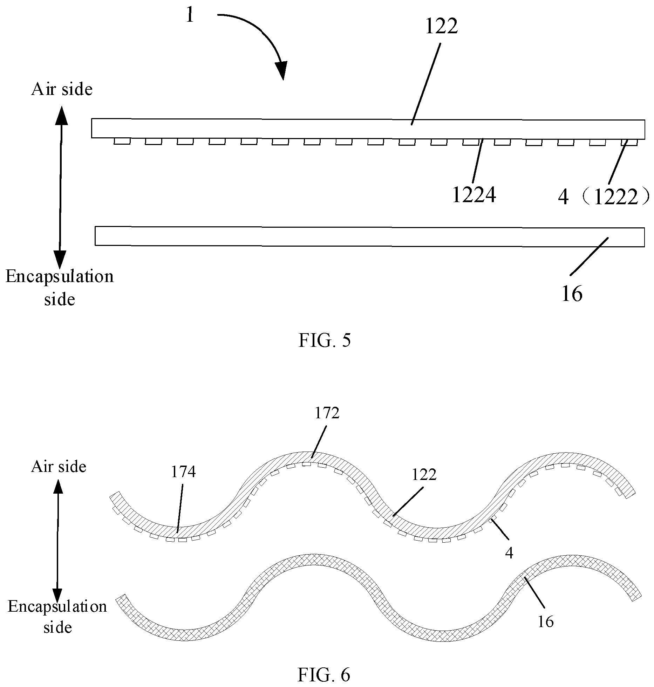

As illustrated in FIG. 5, the panel 12 in a sixth aspect of the present disclosure is applied in the photovoltaic module 1. The panel 12 includes: a visual board 122 including a plurality of coated regions 1222 and non-coated regions 1224 defined by the plurality of coated regions 1222; and a coating 4 applied on each of the plurality of coated regions 1222, each of the plurality of coated regions 1222 having an area greater than or equal to 0.1 mm² and smaller than or equal to 1 mm².

In the panel 12 provided in the present disclosure, the area of each individual coated region 1222 is limited to ensure that the coated regions 1222 are "small in size." In this way, when opaque ink is used, an overall color of the coating 4 can be ensured to be purer. Further, a loss of the light transmittance can be avoided to improve the power generation efficiency while ensuring an overall color purity of the photovoltaic module 1.

It should be noted that, in FIG. 5, an air side refers to a side of the photovoltaic module 1 close to air, an encapsulation side refers to a side of the photovoltaic module 1 facing away from the air, a light-receiving surface refers to a surface facing towards sunlight, and a backlit surface refers to a surface facing away from the sunlight. Corresponding concepts in FIG. 6 to FIG. 10 follow the same logic.

In some technical solutions, in an implementation, an area of each of the plurality of coated regions 1222 is A1; and an area of each of the non-coated regions 1224 is A2, where a value of A1/(A1+A2) is greater than or equal to 0.3 and smaller than or equal to 0.7.

In some technical solutions, in an implementation, the value of A1/(A1+A2) is greater than or equal to 0.4 and smaller than or equal to 0.6.

In these technical solutions, a ratio of the area of each of the plurality of coated regions 1222 to a total area of the coated region 1222 and the non-coated region 1224 is greater than or equal to 0.4 and smaller than or equal to 0.6, e.g., 0.5. By further limiting a proportion of the area of the coated region 1222, the color purity is ensured while guaranteeing transparency.

In some technical solutions, in an implementation, each of the plurality of coated regions 1222 has an area greater than or equal to 0.3 mm² and smaller than or equal to 0.7 mm². In an implementation, each of the plurality of coated regions 1222 has the area of 0.5024mm².

In these technical solutions, the area of each coated region 1222 is much smaller than that of a conventional coated region 1222, which can ensure the light transmittance while maintaining a color quality. However, if the area of each coated region 1222 is set to be smaller than 0.1 mm², manufacturing difficulty is increased. Therefore, setting the area to range from 0.3 mm² to 0.7 mm² is most appropriate.

In some technical solutions, in an implementation, the coating 4 has light transmittance smaller than or equal to 10%.

In these technical solutions, the coating 4 has the light transmittance smaller than or equal to 10%, making an overall color of the coating 4 purer and less likely to mix with the base color. In an implementation, the coating 4 has the light transmittance smaller than or equal to 5%, e.g., 0. In this way, the overall color purity of the photovoltaic module 1 can be further ensured to avoid a mixture with the base color of a cell panel.

In some technical solutions, in an implementation, a composition of the coating 4 mainly includes low-melting-point glass powder or resin, a mixed solvent of xylene and butyraldehyde, high-temperature filler powder, and color powder. The color powder is primarily composed of PbCrO4, nano-calcium, fluorescent paste, and manganese and cobalt metallic compounds.

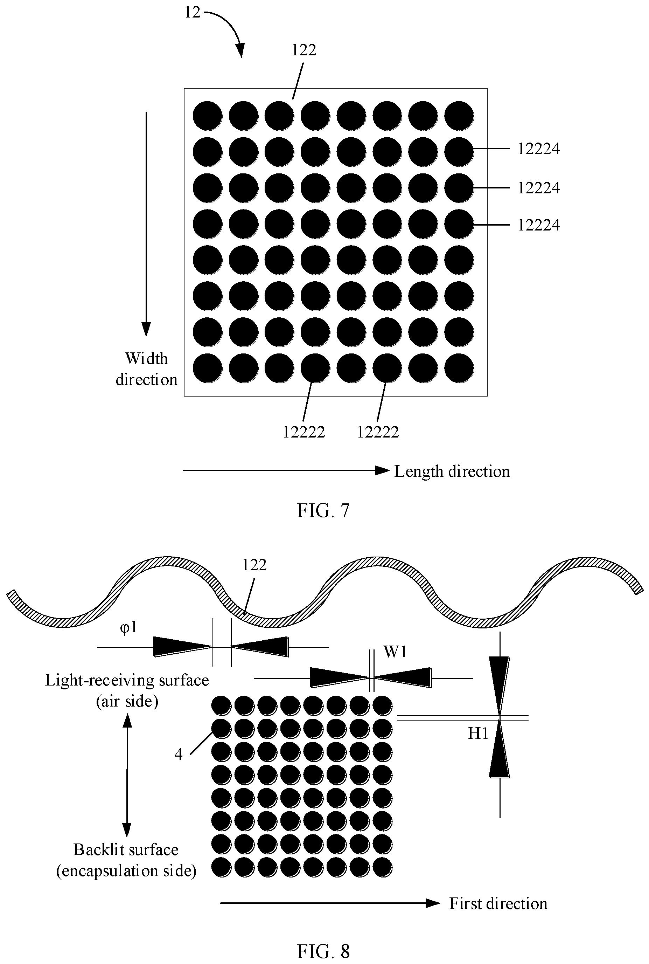

In some technical solutions, in an implementation, as illustrated in FIG. 7, the plurality of coated regions 1222 include: a plurality of first coated regions 12222 arranged at intervals in a length direction of the visual board 122; and a plurality of second coated regions 12224 arranged at intervals in a width direction of the visual board 122. A shortest distance between two adjacent first coated regions 12222 of the plurality of first coated regions 12222 is greater than or equal to 0.1 mm and smaller than or equal to 1 mm. A shortest distance between two adjacent second coated regions 12224 of the plurality of second coated regions 12224 is greater than or equal to 0.1 mm and smaller than or equal to 1 mm.

In these technical solutions, the plurality of coated regions 1222 may be arranged at intervals in the length direction of the visual board 122, the width direction of the visual board 122, or in both the length direction and the width direction of the visual board 122, which can result in higher overall color uniformity. Additionally, since the shortest distance between the two adjacent first coated regions 12222 of the plurality of first coated regions 12222 is greater than or equal to 0.1 mm and smaller than or equal to 1 mm, and the shortest distance between the two adjacent second coated regions 12224 of the plurality of second coated regions 12224 is greater than or equal to 0.1 mm and smaller than or equal to 1 mm, a density of the plurality of coated regions 1222 can be ensured to guarantee the overall color purity.

In some technical solutions, in an implementation, a shortest distance between two adjacent first coated regions 12222 of the plurality of first coated regions 12222 is greater than or equal to 0.1 mm and smaller than or equal to 0.3 mm. In an implementation, the shortest distance between the two adjacent first coated regions 12222 of the plurality of first coated regions 12222 is 0.2 mm.

In some technical solutions, in an implementation, a shortest distance between two adjacent second coated regions 12224 of the plurality of second coated regions 12224 is greater than or equal to 0.1 mm and smaller than or equal to 0.3 mm. In an implementation, the shortest distance between the two adjacent second coated regions 12224 of the plurality of second coated regions 12224 is 0.2 mm.

In these technical solutions, by further limiting the distance between the adjacent coated regions 1222, the overall color of the coating 4 can be ensured to be purer. Further, the loss of the light transmittance can be avoided to improve the power generation efficiency while ensuring the overall color quality of the photovoltaic module 1.

In some technical solutions, in an implementation, the plurality of coated regions 1222 are arranged in an array. A shortest distance between two adjacent coated regions 1222 of the plurality of coated regions 1222 is greater than or equal to 0.1 mm and smaller than or equal to 0.3 mm.

In these technical solutions, in an implementation, the plurality of coated regions 1222 being arranged in the array means that the plurality of coated regions 1222 can be arranged at intervals in the length direction of the visual board 122, the width direction of the visual board 122, or a predetermined direction. The predetermined direction may form an angle with the length direction, e.g., an angle greater than or equal to 40° and smaller than or equal to 50°. For example, the angle may be 45°. In this way, the coating 4 can be arranged in a regular pattern, improving the overall color uniformity.

In some technical solutions, in an implementation, as illustrated in FIG. 7, FIG. 8, FIG. 9, FIG. 10, and FIG. 11, the plurality of coated regions 1222 include one or a combination of circular coated regions, elliptical coated regions, diamond-shaped coated regions, and figure-eight-shaped coated regions.

In these technical solutions, coated regions 1222 such as the circular coated regions, the elliptical coated regions, the diamond-shaped coated regions, and the figure-eight-shaped coated regions can allow for better printing on the one hand. On the other hand, especially for curved panels, the coated regions 1222 of these shapes experience less deformation compared with square coated regions 1222, ensuring the overall color quality.

In some technical solutions, in an implementation, as illustrated in FIG. 7 and FIG. 8, the plurality of coated regions 1222 include circular coated regions. Each of the circular coated regions has a diameter greater than or equal to 0.5 mm and smaller than or equal to 1.0 mm. A distance between centers of two adjacent circular coated regions of the circular coated regions is greater than or equal to 0.05 mm and smaller than or equal to 0.3 mm.

In these technical solutions, for the curved panels, the circular coated regions experience less deformation compared with the square coated regions 1222. Further, by limiting the diameter of each of the circular coated regions and the distance between the centers of the two adjacent circular coated regions of the circular coated regions, an overall density of the circular coated regions can be ensured to guarantee the color purity. In an implementation, the diameter of the circular coated region may be 0.8 mm or 1.0 mm, and the distance between the centers of the two adjacent circular coated regions of the circular coated regions may be 0.1 mm or 0.2 mm.

In some technical solutions, in an implementation, as illustrated in FIG. 6, the panel 12 includes a curved panel. In this way, the satisfactory power generation efficiency can be achieved for different incident angles of sunlight.

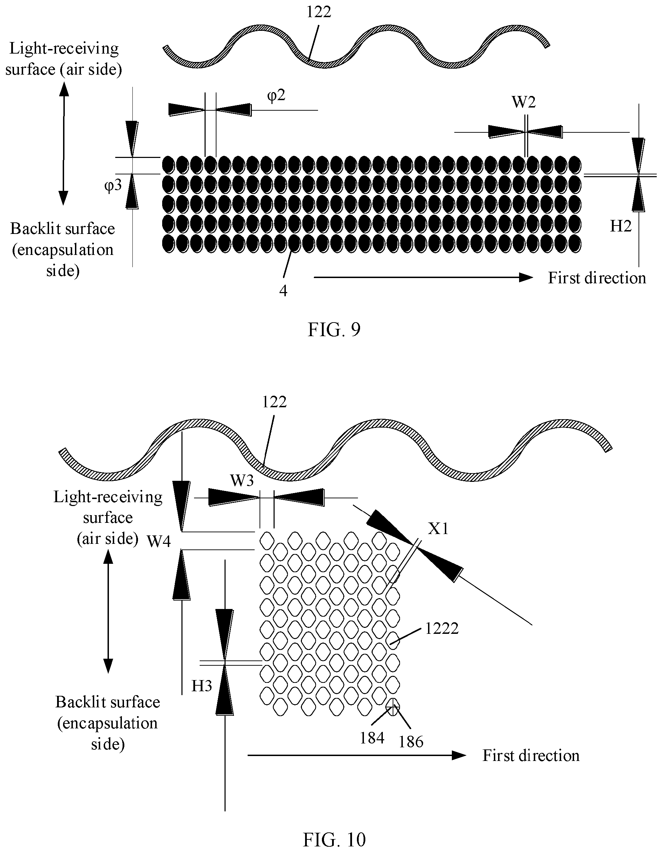

In some technical solutions, in an implementation, as illustrated in FIG. 9, the curved panel 12 includes peaks 172 and valleys 174 that are arranged alternately in a first direction; and each of the plurality of coated regions 1222 is in a shape of an ellipse. A direction of a minor axis of the ellipse is the same as the first direction.

In these technical solutions, since the direction of the minor axis of the ellipse is the same as the first direction, more elliptical coated regions can be arranged within a same volume, ensuring the color purity. The first direction may also be regarded as a bending direction of the curved panel.

In some technical solutions, in an implementation, as illustrated in FIG. 10, the curved panel 12 includes a peak 172 and a valley 174 that are arranged alternately in a first direction; and each of the plurality of coated regions 1222 is in a shape of a diamond. The diamond includes a first diagonal 184 and a second diagonal 186. The first diagonal 184 has a greater length than the second diagonal 186. An extension direction of the second diagonal 186 is the same as the first direction.

In these technical solutions, when each of the plurality of coated regions 1222 is in the shape of the diamond, an extension direction of a shorter diagonal is the same as the first direction, which allows for more coated regions 1222 to be arranged within a same volume, ensuring the color purity.

In some technical solutions, in an implementation, any two nearest coated regions 1222 of the plurality of coated regions 1222 are offset from each other.

In these technical solutions, when each of the plurality of coated regions 1222 is in the shape of the diamond, the any two nearest coated regions 1222 of the plurality of coated regions 1222 are offset from each other, which allows for more coated regions 1222 to be arranged within a same volume, ensuring the color purity.

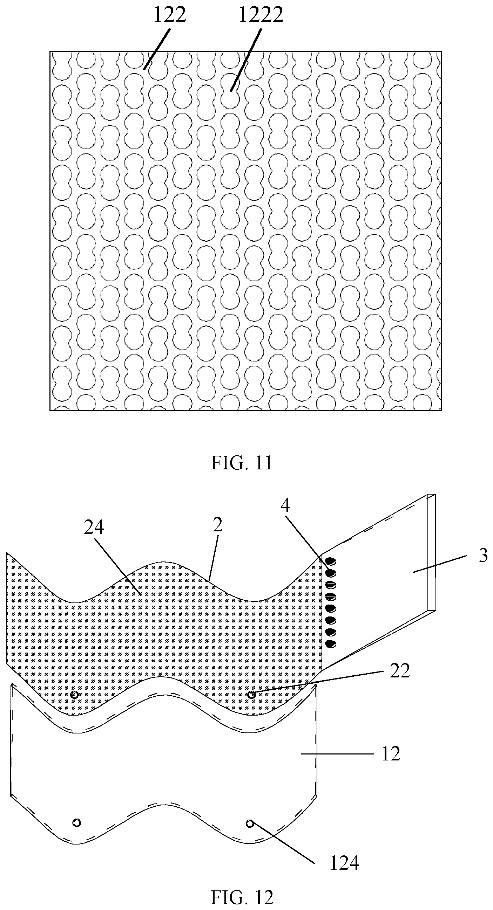

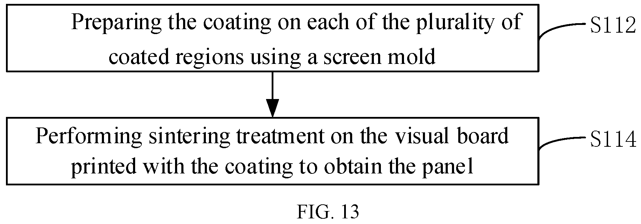

As illustrated in FIG. 12 and FIG. 13, in a seventh aspect of the present disclosure, a method for preparing a panel is provided. The method is applied in preparing the panel 12 according to any of the embodiments in the sixth aspect of the present disclosure. The method includes operations at blocks.

At S112, the coating is prepared at each of the plurality of coated regions using a screen mold.

At S114, sintering treatment is performed on the visual board printed with the coating to obtain the panel.

With the method of the present disclosure, the overall screen printing is adjusted to the partial screen printing, which not only ensures the overall aesthetics of the panel 12 of the photovoltaic module 1, but also guarantees that the photovoltaic module 1 has the high generated power, reducing the losses in the power generation efficiency due to the unsatisfactory light transmittance.

In an implementation, as illustrated in FIG. 12, during printing of the coating 4, the screen mold 2 is positioned through the mold holes 22 and the positioning holes 124 at the upper end of the panel 12. The ink is poured into the screen mold 2. The screen printing is performed at a speed ranging from 20 m/min to 30 m/min. The ink on the screen mold 2 is evenly spread as it is pushed by the squeegee. The ink thickness ranges from 20 µm to 30 µm.

In some technical solutions, in an implementation, the method further includes, prior to the preparing the coating on each of the plurality of coated regions using the screen mold: treating a visual board using a lipophilic treatment agent.

In these technical solutions, the visual board 122 is first treated with the lipophilic treatment agent, which can improve the bonding strength between the coating 4 and the visual board 122 subsequent to the screen printing.

In some technical solutions, in an implementation, the lipophilic treatment agent includes at least one of hexamethyldisiloxane, trimethylsiloxane, or dimethylchlorosilane.

In these technical solutions, by selecting the lipophilic treatment agent, the bonding strength between ink and the visual board 122 can be further improved, avoiding the problem of ink detachment.

In some technical solutions, in an implementation, during the sintering treatment, the sintering temperature is greater than or equal to 400°C and smaller than or equal to 1,000°C. In an implementation, the sintering temperature is greater than or equal to 400°C and smaller than or equal to 700°C. For example, the sintering temperature may be 500°C or 600°C.

In some technical solutions, in an implementation, the screen mold 2 has through holes 24 corresponding to the plurality of coated regions 1222, respectively. A quantity of through holes 24 per square inch of the screen mold 2 is greater than or equal to 250 and smaller than or equal to 300.

In this embodiment, limiting the quantity of through holes 24 per square inch of the screen mold 2 to range from 250 to 300 further improves the aesthetic appeal and the light transmittance. In an implementation, the quantity of through holes 24 may be 250, 270, or 300.

As illustrated in FIG. 5, according to technical solutions in an eighth aspect of the present disclosure, a photovoltaic module 1 is provided. The photovoltaic module 1 includes: the panel 12 according to any of the technical solutions in the sixth aspect of the present disclosure; or the panel 12 prepared by the method according to any of the technical solutions in the seventh aspect of the present disclosure. Since the photovoltaic module 1 provided in the present disclosure includes the panel 12 according to any of the technical solutions in the sixth aspect of the present disclosure or the panel 12 prepared by the method according to any of the technical solutions in the seventh aspect of the present disclosure, the photovoltaic module 1 possesses all the advantageous effects of the panel 12 according to any of the technical solutions in the sixth aspect of the present disclosure, and thus details thereof will be omitted here.

In some technical solutions, in an implementation, the photovoltaic module 1 further includes a battery layer 16 disposed on a side of the panel 12. The coating 4 is disposed between the visual board 122 and the battery layer 16.

In this embodiment, since the coating 4 is disposed between the visual board 122 and the battery layer 16, the visual board 122 can provide a predetermined level of protection to the coating 4, to prevent the coating 4 from being damaged by the external force and avoid damage caused by long-term exposure of the coating 4 to an outer side.

According to another embodiment of the present disclosure, a screen printing process for the photovoltaic module 1 is provided. Ink is adhered to a glass substrate (i.e., the visual board 122 of the present disclosure) through the screen printing. The ink used is high-temperature-resistant specialty ink. Then, the ink is attached to the glass substrate through high-temperature sintering treatment. The specialty ink is resistant to a temperature ranging from 400°C to 1,000°C, ensuring satisfactory performance even at a high temperature. The coating 4 is located at an inner side of the photovoltaic product, i.e., between the visual board 122 and the battery layer 16. The screen mold 2 has the mesh count ranging from 250 to 300 (e.g., 300, which ensures a dense screen and a thin substrate, preventing the ink from spreading outwards after the screen printing is completed). The ink has the light transmittance <10%. In an implementation, the ink is opaque, ensuring accurate color representation. A composition of the high-temperature ink may include low-melting-point glass powder or resin, a mixed solvent of xylene and butyraldehyde, high-temperature filler powder, and color powder. The color powder is primarily composed of PbCrO4, nano-calcium, fluorescent paste, and manganese and cobalt metallic compounds. The screen-printed pattern is a dot matrix array. Each dot has an area ranging from 0.5 mm²±0.2 mm², e.g., 0.5024 mm². An area proportion of the screen-printed pattern is 50%±10%, with the remaining area left unprinted to ensure sufficient and uniform light transmission. This solution is also applicable to curved photovoltaic modules.

As illustrated in FIG. 8, each of the coated regions 1222 may be in a shape of a dot and has a diameter φ1 ranging from 0.5 mm to 1.0 mm (which may be 0.8 mm), and each of a left-right distance W1 and an up-down distance H1 between the dots ranges from 0.05 mm to 0.3 mm (which may be 0.2 mm), ensuring the required area ratio.

As illustrated in FIG. 9, each coated region 1222 may be in the shape of the ellipse. The ellipse has a diameter φ2 satisfying φ2<φ3. The minor axis of the ellipse is arranged in a bending direction of the glass. Similarly, the area proportion is ensured. In the length direction of the visual board 122, the spacing W2 between two adjacent coated regions 1222 ranges from 0.05 mm to 0.3 mm, e.g., 0.2 mm. In the width direction of the visual board 122, the spacing H2 between two adjacent coated regions 1222 ranges from 0.05 mm to 0.3 mm, e.g., 0.2 mm.

Additionally, as illustrated in FIG. 10 and FIG. 11, each of coated regions 1222 may be in a shape of a diamond or figure eight. In a case where the coated region 1222 is in the shape of the diamond, W3<W4, with W3 arranged in the bending direction of the glass. The coated regions 1222 are arranged to be offset from each other. The spacing X1 between two coated regions 1222 offset from each other ranges from 0.05 mm to 0.3 mm, e.g., 0.2 mm, ensuring the proportion ratio. In the width direction of the visual board 122, the spacing H3 between two adjacent coated regions 1222 ranges from 0.05 mm to 0.3 mm.

In this embodiment, the panel 12 achieves uniform distribution of fine dot-shaped ink, in such a manner that each PN junction of a photovoltaic cell (where P represents P-type, i.e., positive type, and N represents N-type, i.e., negative type) can be effectively activated, and a hot spot effect is less likely to occur, maximizing power while maintaining a consistent appearance.

Reference throughout this specification to "an embodiment", "some embodiments", "an illustrative embodiment", "an example", "a specific example", or "some examples" means that a particular feature, structure, material, or characteristic described in connection with the embodiment or example is included in at least one embodiment or example of the present disclosure. The appearances of the above phrases in various places throughout this specification are not necessarily referring to the same embodiment or example. Further, the particular features, structures, materials, or characteristics may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. A panel, applied in a photovoltaic module, the panel comprising:
a visual board comprising a plurality of coated regions arranged in an array and non-coated regions defined by the plurality of coated regions; and
a coating applied on each of the plurality of coated regions.

2. The panel according to claim 1, wherein:
a spacing between two adjacent coated regions of the plurality of coated regions ranges from 5 mm to 10 mm; and/or
each of the plurality of coated regions has a width and a length each ranging from 2 mm to 5 mm.

3. The panel according to claim 1 or 2, wherein a quantity of coated regions per square inch of the visual board is greater than or equal to 10 and smaller than or equal to 1,000.

4. The panel according to claim 3, wherein the quantity of coated regions per square inch of the visual board is greater than or equal to 150 and smaller than or equal to 250.

5. The panel according to any one of claims 1 to 4, further comprising:
at least two positioning holes spaced apart at the visual board, each of the at least two positioning holes extending in a thickness direction of the visual board.

6. The panel according to any one of claims 1 to 5, wherein:
a maximum distance between any two points in each of the plurality of coated regions is a first distance; and
a minimum distance between any two adjacent coated regions of the plurality of coated regions is a second distance, a ratio of the first distance to the second distance being greater than or equal to 0.5 and smaller than or equal to 1.5.

7. The panel according to any one of claims 1 to 6, wherein the coating is made of transparent pearlescent ink.

8. The panel according to claim 7, wherein:
the transparent pearlescent ink is capable of absorbing light having a wavelength greater than or equal to 100 nm and smaller than 300 nm; and
the transparent pearlescent ink is capable of transmitting light having a wavelength greater than or equal to 300 nm and smaller than or equal to 1,100 nm.

9. The panel according to any one of claims 1 to 6, wherein the panel has light transmittance greater than or equal to 85%.

10. The panel according to any one of claims 1 to 6, wherein the coating has a thickness greater than or equal to 20 µm and smaller than or equal to 30 µm.

11. The panel according to any one of claims 1 to 6, wherein:
the visual board comprises a curved structure having a radius greater than or equal to 30 mm and smaller than or equal to 150 mm; and/or
the visual board has a thickness greater than or equal to 3 mm and smaller than or equal to 8 mm.

12. A photovoltaic module, comprising the panel according to any one of claims 1 to 11.

13. The photovoltaic module according to claim 12, further comprising:
a backplane layer disposed on a side of the panel facing away from the coating;
a battery layer disposed between the backplane layer and the panel;
a first adhesive layer disposed between the panel and the battery layer; and
a second adhesive layer disposed between the backplane layer and the battery layer.

14. A method for preparing a panel, the method comprising:
treating a visual board using a lipophilic treatment agent, the visual board comprising coated regions and non-coated regions defined by the coated regions; and
preparing a coating on each of the coated regions using a screen mold to obtain the panel.

15. The method for preparing the panel according to claim 14, wherein the lipophilic treatment agent comprises at least one of hexamethyldisiloxane, trimethylsiloxane, or dimethylchlorosilane.

16. The method for preparing the panel according to claim 14 or 15, wherein the screen mold has through holes corresponding to the coated regions, respectively, a quantity of through holes per square inch of the screen mold being greater than or equal to 10 and smaller than or equal to 1,000.

17. The method for preparing the panel according to claim 16, wherein the quantity of through holes per square inch of the screen mold is greater than or equal to 150 and smaller than or equal to 250.

18. A panel, applied in a photovoltaic module, the panel comprising:
a visual board comprising a plurality of coated regions and non-coated regions defined by the plurality of coated regions; and
a coating applied on each of the plurality of coated regions, wherein each of the plurality of coated regions has an area greater than or equal to 0.1 mm² and smaller than or equal to 1 mm².

19. The panel according to claim 18, wherein:
an area of each of the plurality of coated regions is A1; and
an area of each of the non-coated regions is A2, wherein a value of A1/(A1+A2) is greater than or equal to 0.3 and smaller than or equal to 0.7.

20. The panel according to claim 19, wherein the value of A1/(A1+A2) is greater than or equal to 0.4 and smaller than or equal to 0.6.

21. The panel according to claim 18, wherein:
each of the plurality of coated regions has an area greater than or equal to 0.3 mm² and smaller than or equal to 0.7 mm²; and/or
the coating has light transmittance smaller than or equal to 10%.

22. The panel according to claim 18, wherein the plurality of coated regions comprise:
a plurality of first coated regions arranged at intervals in a length direction of the visual board; and
a plurality of second coated regions arranged at intervals in a width direction of the visual board, a shortest distance between two adjacent first coated regions of the plurality of first coated regions being greater than or equal to 0.1 mm and smaller than or equal to 1 mm, and a shortest distance between two adjacent second coated regions of the plurality of second coated regions being greater than or equal to 0.1 mm and smaller than or equal to 1 mm.

23. The panel according to claim 18, wherein the plurality of coated regions are arranged in an array, a shortest distance between two adjacent coated regions of the plurality of coated regions being greater than or equal to 0.1 mm and smaller than or equal to 0.3 mm.

24. The panel according to any one of claims 18 to 23, wherein the plurality of coated regions comprise one or a combination of circular coated regions, elliptical coated regions, diamond-shaped coated regions, and figure-eight-shaped coated regions.

25. The panel according to claim 18, wherein the plurality of coated regions comprise circular coated regions, each of the circular coated regions having a diameter greater than or equal to 0.5 mm and smaller than or equal to 1.0 mm, and a distance between centers of two adjacent circular coated regions of the circular coated regions being greater than or equal to 0.05 mm and smaller than or equal to 0.3 mm.

26. The panel according to any one of claims 18 to 25, wherein the panel comprises a curved panel.

27. The panel according to 26, wherein the curved panel comprises peaks and valleys that are arranged alternately in a first direction, wherein each of the plurality of coated regions is in a shape of an ellipse, a direction of a minor axis of the ellipse being the same as the first direction.

28. The panel according to claim 26, wherein the curved panel comprises peaks and valleys that are arranged alternately in a first direction, wherein each of the plurality of coated regions is in a shape of a diamond, the diamond comprising a first diagonal and a second diagonal, the first diagonal having a greater length than the second diagonal, and an extension direction of the second diagonal being the same as the first direction.

29. The panel according to claim 28, wherein any two nearest coated regions of the plurality of coated regions are offset from each other.

30. A method for preparing a panel, applied in preparing the panel according to any one of claims 18 to 29, the method comprising:
preparing the coating on each of the plurality of coated regions using a screen mold; and
performing sintering treatment on the visual board printed with the coating to obtain the panel.

31. The method for preparing the panel according to claim 30, wherein:
during the sintering treatment, a sintering temperature is greater than or equal to 400°C and smaller than or equal to 1,000°C; and/or
the screen mold has through holes corresponding to the coated regions, respectively, a quantity of through holes per square inch of the screen mold being greater than or equal to 250 and smaller than or equal to 300.

32. A photovoltaic module, comprising:
the panel according to any one of claims 18 to 29; or
the panel prepared using the method for preparing the panel according to claim 30 or 31.

33. The photovoltaic module according to claim 32, further comprising a battery layer disposed on a side of the panel, the coating being disposed between the visual board and the battery layer.
